# EUROPEAN PATENT SPECIFICATION

(11) **EP 2 630 725 B1**
(45) Date of publication and mention of the grant of the patent: **27.02.2019**
(21) Application number: 11834711.1
(22) Date of filing: 21.10.2011
(51) Int. Cl.: H02P 29/02, G01R 19/165, G01R 31/34, G01R 31/42, G01R 31/02

(54) **DEVICE AND METHOD FOR FUNCTION DETECTION IN A FEED CONFIGURATION**
VORRICHTUNG UND VERFAHREN ZUR FUNKTIONSERKENNUNG IN EINER ZUFUHRKONFIGURATION
DISPOSITIF ET PROCÉDÉ DE DÉTECTION D'UNE FONCTION DANS UNE CONFIGURATION D'ALIMENTATION

(30) Priority: 22.10.2010 SE 1051100
(43) Date of publication of application: 28.08.2013
(73) Proprietor: Scania CV AB, 151 87 Södertälje (SE)
(72) Inventor: ZAMANI, Sebastian, S-112 16 Stockholm (SE); MARKUSSON, Christoffer, S-151 44 Södertälje (SE)
(74) Representative: Scania CV AB
(86) International application number: PCT/SE2011/000184
(87) International publication number: WO 2012/053954

(56) References cited:
- EP-A1- 2 219 041
- WO-A1-86/01904
- WO-A1-86/01904
- US-A- 5 049 815
- US-A1- 2009 009 920
- US-A1- 2009 309 575
- US-A1- 2009 309 575

## Description

### TECHNICAL FIELD

The present invention relates to a method for function detection in a feed configuration which comprises feed lines, an electronic conversion unit and a three-phase electric motor. The invention relates also to a computer programme product containing programme code for a computer for implementing a method according to the invention. The invention relates also to a device for function detection in a feed configuration which comprises feed lines, an electronic conversion unit and a three-phase electric motor, and to a motor vehicle equipped with the device.

### BACKGROUND

Today's vehicles use, for example, AdBlue (water + 32.5% urea) as reductant in SCR (selective catalytic reduction) systems provided with an SCR catalyst in which said reductant and NOx gases can react and be converted to nitrogen gas and water.

When fitting SCR systems, certain vehicle manufacturers use for feeding of the reductant in the SCR system a device supplied by a subcontractor. The feed device comprises an electric motor which drives a pump to pressurise the reductant in the SCR system. This feed device does not itself comprise any diagnostic functions for determining possible fault states.

Like practically all electromechanical components of vehicles or other industrial applications, the feed device is liable to be affected by fault states or operational malfunctions of various kinds. It is desirable to be able reliably to determine possible operational malfunctions of a feed device which is incorporable in, for example, an SCR system of a motor vehicle.

There is thus a need to propose a method for being able to diagnose the feed device reliably in a distributed system, e.g. an SCR system of a motor vehicle.

US 4744041 describes a method for testing a DC motor.

US 7340158 describes a method for controlling a multi-phase brushless electric motor whereby a peak value of a current in a return line is detected and is used to control the motor.

### SUMMARY OF THE INVENTION

An object of the present invention is to propose a novel and advantageous method for function detection in a feed configuration which comprises feed lines, an electronic conversion unit and a three-phase electric motor.

Another object of the invention is to propose a novel and advantageous device and a novel and advantageous computer programme for function detection in a feed configuration which comprises feed lines, an electronic conversion unit and a three-phase electric motor.

A further object of the invention is to propose a method, a device and a computer programme for applying a more robust method for function detection in a feed configuration.

A further object of the invention is to propose a method, a device and a computer programme for effecting a function detection in a feed configuration in cases where determining a function detection cannot be done in said feed configuration.

Another object of the invention is to propose an alternative way of effecting a function detection in a feed configuration.

Another object of the invention is to propose a robust way of determining a fault state of an SCR system of a motor vehicle.

These objects are achieved with a method for function detection in a feed configuration which comprises feed lines, an electronic conversion unit and a three-phase electric motor, according to claim 1.

An aspect of the invention proposes a method for function detection in a feed configuration which comprises feed lines, an electronic conversion unit and a three-phase electric motor, comprising the steps of
- detecting a response signal in a feed line for the feed configuration,
- detecting levels of specific sections of said response signal,
- comparing levels thus detected of said specific sections of said response signal with a predetermined threshold level over a predetermined period of time, and
- determining an unwanted function of the feed configuration if all of the levels thus detected of said specific sections of said response signal are below said predetermined threshold level over said predetermined period of time.

Said unwanted function may be determined by means of a unit separate from feed configuration, e.g. by an external connectable control unit. Robust detection of a function state of the feed configuration may thus be achieved in a distributed system.

Said response signal may be detected in the form of a current signal. By measuring a voltage across a known electrical resistance, e.g. on a return side of the feed configuration, it is possible to determine an existing electric current. The result is a robust method for determining a function state of the feed configuration without having to install any extra components of the feed device. Cost-effective implementation of the present invention is thus achieved, particularly as one extra necessary component (resistor) will be relatively inexpensive.

Said specific sections of said response signal may comprise a peak value of a wave motion of the current signal. Taking account of only the peak values of the current signal results in a method for function detection which involves quite little computing capacity. Any suitable algorithms may be used to easily determine the peak values of the current signal, e.g. by cross-sampling the signal and then filtering away all measuring points except the peak values of the wave motion.

The method may further comprise the step of comparing said threshold level with certain detected levels of said specific sections of said response signal. To make the process of comparing said detected levels of said specific sections with said comparison level still more effective, a highest level from among a number of successive levels detected may be saved separately for comparison. Selecting and saving separately the highest value of, for example, 5 or 10 wave motion sections and then comparing these selected peak values with said threshold level results in an alternative method for function detection. An advantage of this method is that it involves fewer comparisons between levels detected and said threshold level, with consequently less risk of computing error.

Said levels detected of said specific sections of said response signal may relate to a highest level within predetermined wave motion periods. Taking account of only a highest level within predetermined wave motion periods results in a more reliable method for function detection in that some alternatives, e.g. comparisons based on mean values, do not allow proper data processing for existing subsystems (control unit and feed configuration). Detection systems for higher-resolution analysis of the response signal may be regarded as too expensive for implementation according to the invention. Taking account of only peak values of the response signal avoids analysing the whole signal, which would involve large amounts of time and resources and be complicated because of the characteristics of the response signal.

Said period of time may be within a range of between 0.5 and 10 seconds. It may be within any suitable range. It may be less than 0.5 seconds. It may be longer than 10 seconds. According to a preferred version, it is 5 seconds. This affords the advantage of providing a good enough basis for function detection while at the same time limiting the computing capacity required and thereby advantageously releasing computing resources for other applications.

Said threshold level may be within a range of between 10 and 100 mA (milliamperes). According to a version, it is 25 mA. The threshold level set does of course need to be appropriate to the dimensions of the feed configuration. It may be any suitable level.

The feed configuration may relate to an arrangement for a reducing agent pump for an exhaust cleaning arrangement.

The method is easy to implement in existing motor vehicles. Software for function detection in a feed configuration which comprises feed lines, an electronic conversion unit and a three-phase electric motor may be installed in a control unit of the vehicle during the manufacture of the vehicle. A purchaser of the vehicle may thus have the possibility of selecting the function of the method as an option. Alternatively, software which comprises programme code for applying the innovative method for function detection in a feed configuration which comprises feed lines, an electronic conversion unit and a three-phase electric motor may be installed in a control unit of the vehicle on the occasion of upgrading at a service station, in which case the software may be loaded into a memory in the control unit. Implementing the innovative method is therefore cost-effective, particularly since no further components need be installed in the feed configuration. Relevant hardware is currently already present in the feed configuration. The invention therefore represents a cost-effective solution to the problems indicated above.

Software containing programme code for function detection in a feed configuration which comprises feed lines, an electronic conversion unit and a three-phase electric motor is easy to update or replace. Moreover, different parts of the software containing programme code for function detection in a feed configuration which comprises feed lines, an electronic conversion unit and a three-phase electric motor may be replaced independently of one another. This modular configuration is advantageous from a maintenance perspective.

An aspect of the invention proposes a device for function detection in a feed configuration which comprises feed lines, an electronic conversion unit and a three-phase electric motor, according to claim 10.

An aspect of the invention proposes a device for function detection in a feed configuration which comprises feed lines, an electronic conversion unit and a three-phase electric motor, comprising
- means for detecting a response signal in a feed line for the feed configuration,
- means for detecting levels of specific sections of said response signal,
- means for comparing levels thus detected of said specific sections of said response signal with a predetermined threshold level over a predetermined period of time, and
- means for determining an unwanted function of the feed configuration if all of the levels thus detected of said specific sections of said response signal are below said predetermined threshold level over said predetermined period of time.

Said means for determining an unwanted function of the feed configuration may be a unit separate from the feed configuration.

Said means for detecting the response signal may be adapted to detecting a current signal.

Said specific sections of said response signal may comprise a peak value of a wave motion of the current signal.

The device may further comprise means for comparing said threshold level with certain levels detected of said specific sections of said response signal.

Said levels detected of said specific sections of said response signal may relate to a highest level within predetermined wave motion periods.

Said periods of time may be within a range of between 0.5 and 10 seconds. Said threshold level may be within a range of between 10 and 100 mA (milliamperes).

The feed configuration may relate to an arrangement for a reducing agent pump for an exhaust cleaning arrangement.

The above objects are also achieved with a motor vehicle which comprises the features according to the device for function detection in a feed configuration which comprises feed lines, an electronic conversion unit and a three-phase electric motor. The vehicle may be a truck, bus or passenger car.

An aspect of the invention proposes a computer programme for function detection in a feed configuration which comprises feed lines, an electronic conversion unit and a three-phase electric motor, which programme contains programme code stored on a computer-readable medium for causing an electronic control unit or another computer connected to the electronic control unit to perform steps according to any of claims 1-9.

An aspect of the invention proposes a computer programme product containing a programme code stored on a computer-readable medium for performing method steps according to any of claims 1-9 when said programme is run on an electronic control unit or another computer connected to the electronic control unit.

Further objects, advantages and novel features of the present invention will become apparent to one skilled in the art from the following details, and also by putting the invention into practice. Whereas the invention is described below, it should be noted that it is not restricted to the specific details described. Specialists having access to the teachings herein will recognise further applications, modifications and incorporations within other fields, which are within the scope of the invention.

### BRIEF DESCRIPTION OF THE DRAWINGS

For fuller understanding of the present invention and further objects and advantages of it, the detailed description set out below should be read in conjunction with the accompanying drawings, in which the same reference notations denote similar items in the various diagrams, and in which:
Figure 1 illustrates schematically a vehicle according to an embodiment of the invention;
Figure 2 illustrates schematically a subsystem for the vehicle depicted in Figure 1, according to an embodiment of the invention;
Figure 3a illustrates schematically a device for function detection in a feed configuration, according to an embodiment of the invention;
Figure 3b illustrates schematically a response signal of the device illustrated in Figure 3a, according to an embodiment of the invention;
Figure 3c illustrates schematically a response signal of the device illustrated in Figure 3a, according to an embodiment of the invention;
Figure 4a is a schematic flowchart of a method according to an embodiment of the invention;
Figure 4b is a more detailed schematic flowchart of a method according to an embodiment of the invention; and
Figure 5 illustrates schematically a computer according to an embodiment of the invention.

### DETAILED DESCRIPTION OF THE DRAWINGS

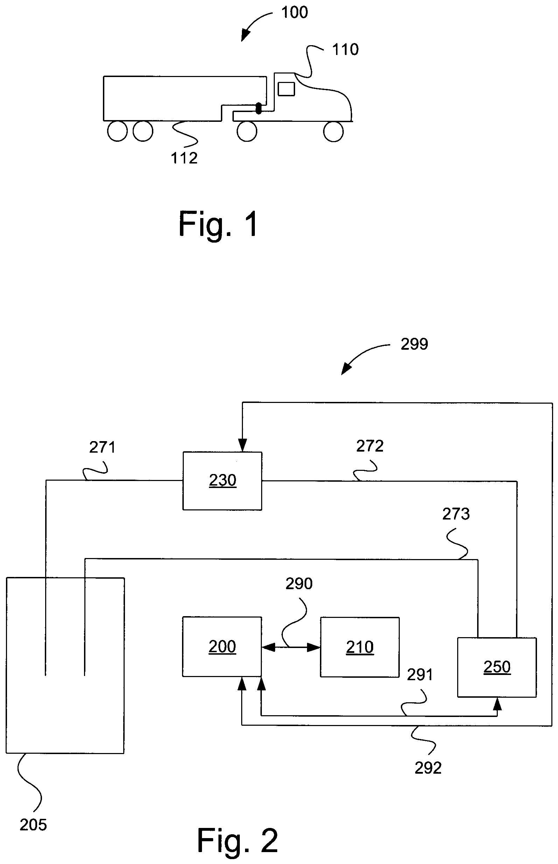

Figure 1 depicts a side view of a vehicle 100. The exemplified vehicle 100 comprises a tractor unit 110 and a trailer 112. The vehicle may be a heavy vehicle, e.g. a truck or a bus. It may alternatively be a car.

It should be noted that the invention is applicable to any SCR system and is therefore not restricted to SCR systems of motor vehicles. The innovative method and the innovative device according to an aspect of the invention are well suited to other platforms which comprise an SCR system than motor vehicles, e.g. watercraft. The watercraft may be of any kind, e.g. motorboats, steamers, ferries or ships.

The innovative method and the innovative device according to an aspect of the invention are also well suited to, for example, systems which comprise industrial engines and/or engine-powered industrial robots.

The innovative method and the innovative device according to an aspect of the invention are also well suited to various kinds of power plants, e.g. an electric power plant provided with a diesel generator.

The innovative method and the innovative device are well suited to any engine system which comprises an engine and an SCR system, e.g. on a locomotive or some other platform.

The innovative method and the innovative device are well suited to any system which comprises an NOₓ generator and an SCR system.

It should be noted that the invention is very well suited to many different types of feed configurations which comprise an electric motor powered by a multi-phase source and adapted to driving various types of devices. The electric motor therefore need not drive merely a pump device of an SCR system of a vehicle.

The term "link" refers herein to a communication link which may be a physical connection such as an opto-electronic communication line, or a non-physical connection such as a wireless connection, e.g. a radio link or microwave link.

The term "line" refers herein to a passage for holding and conveying a fluid, e.g. a reductant in liquid form. The line may be a pipe of any suitable size. The line may be made of any suitable material, e.g. plastic, rubber or metal.

The term " line" refers also herein to an electrical line which may be made of any suitable material, e.g. copper.

The term "reductant" or "reducing agent" refers herein to an agent used for reacting with certain emissions in an SCR system. These emissions may for example be NOx gases. The terms "reductant" and "reducing agent" are herein used synonymously. Said reductant according to a version is so-called AdBlue. Other kinds of reductants may of course be used. AdBlue is herein cited as an example of a reductant.

Figure 2 depicts a subsystem 299 of the vehicle 100. The subsystem 299 is situated in the tractor unit 110. The subsystem 299 may be part of an SCR system. The subsystem 299 comprises in this example a container 205 arranged to hold a reductant. The container 205 is adapted to containing a suitable amount of reductant and to being replenishable as necessary. It might accommodate, for example, 75 or 50 litres of reductant.

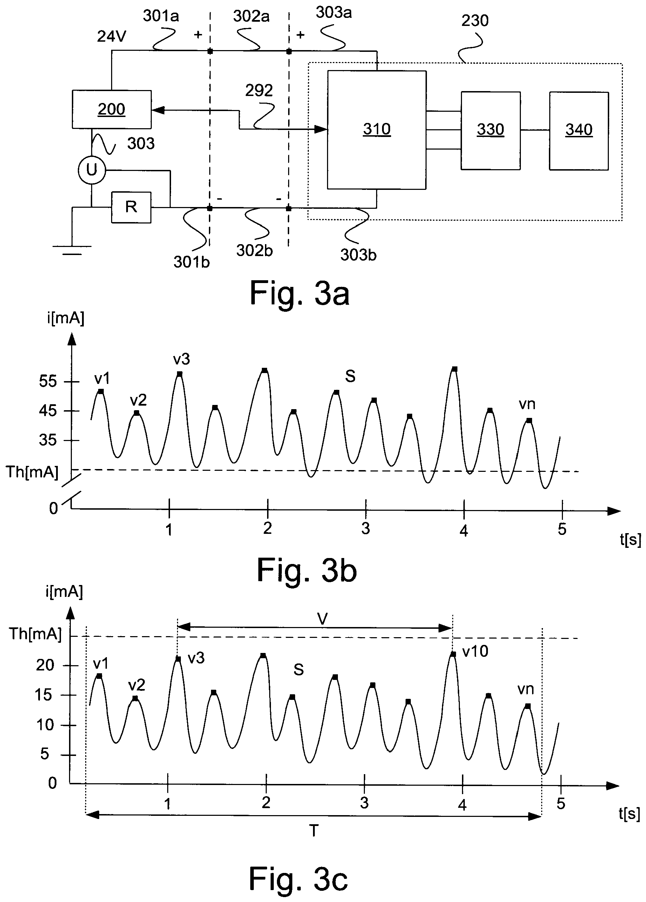

A first line 271 is provided to lead the reductant to a feed configuration 230 from the container 205. The feed configuration 230 may comprise any suitable pump. The pump may be a diaphragm pump provided with at least one filter. The pump is adapted to being driven by an electric motor. Said electric motor is a multi-phase motor. In this embodiment example, the electric motor is a three-phase motor. It may be a three-phase brushless DC motor. The feed configuration 230 comprises also a control unit, e.g. a control card, and an electrical conversion device, e.g. a six-pulse bridge. The feed configuration 230 will be described below in more detail, e.g. with reference to Figure 3.

The feed configuration 230 is adapted to drawing the reductant from the container 205 via the first line 271 and supplying it via a second line 272 to a dosing unit 250. The dosing unit 250 comprises an electrically controlled dosing valve by means of which a flow of reductant added to the exhaust system can be controlled. The pump 230 is adapted to pressurising the reductant in the second line 272. The dosing unit 250 is provided with a throttle unit against which said pressure of the reductant is built up in the subsystem 299.

The dosing unit 250 is adapted to supplying said reductant to an exhaust system (not depicted) of the vehicle 100. More specifically, the dosing unit 250 is adapted to supplying a suitable amount of reductant in a controlled way to an exhaust system of the vehicle 100. According to this version, an SCR catalyst (not depicted) is situated downstream of a location in the exhaust system where the reductant supply takes place. The amount of reductant supplied in the exhaust system is intended to be used in a conventional way in the SCR catalyst to reduce in a known way the amount of undesirable emissions.

The dosing unit 250 is situated adjacent to, for example, an exhaust pipe which is adapted to leading exhaust gases from a combustion engine (not depicted) of the vehicle 100 to the SCR catalyst. The dosing unit 250 is provided with an electronic control card adapted to handling communication with a control unit 200.

A third line 273 runs between the dosing unit 250 and the container 205. The third line 273 is adapted to leading back to the container 205 a certain amount of the reductant fed to the dosing valve 250. This configuration achieves with advantage cooling of the dosing unit 250. The dosing unit 250 is thus cooled by a flow of the reductant being pumped through it from the pump 230 to the container 205.

The first control unit 200 is arranged for communication with the feed configuration 230 via a link 292. The first control unit 200 is adapted to controlling operation of the feed configuration 230 in order for example to regulate the reductant flows within the subsystem 299 by controlling the electric motor of the feed configuration by means of the control unit incorporated in it and the conversion device.

The first control unit 200 is arranged for communication with the dosing unit 250 via a link 291. The first control unit 200 is adapted to controlling operation of the dosing unit 250 in order for example to regulate the reductant supply to the exhaust system of the vehicle 100. The first control unit 200 is adapted to controlling operation of the dosing unit 250 in order for example to regulate the reductant return supply to the container 205.

A second control unit 210 is arranged for communication with the first control unit 200 via a link 290. The second control unit 210 may be detachably connected to the first control unit 200. The second control unit 210 may be a control unit external to the vehicle 100. The second control unit 210 may be adapted to performing the innovative method steps according to the invention. The second control unit 210 may be used to cross-load software to the first control unit 200, particularly software for applying the innovative method. The second control unit 210 may alternatively be arranged for communication with the first control unit 200 via an internal network in the vehicle. The second control unit 210 may be adapted to performing substantially similar functions to those of the first control unit 200, e.g. effecting a function detection of the feed configuration 230, in accordance with the innovative method. It should be noted that the innovative method may be applied by the first control unit 200 or the second control unit 210, or by both the first control unit 200 and the second control unit 210. When the second control unit applies the innovative method, the first control unit 200 may be adapted to passing on a response signal S on a return side of the feed configuration 230.

Figure 3a illustrates schematically a device for function detection in a feed configuration 230, according to an embodiment of the invention. In this example a control device 200 is arranged for communication with a control device (not depicted) which is comprised in an electrical conversion device 310 via a link 292. In cases where the feed configuration is not part of an SCR system of a vehicle, an alternative link may of course be used for said communication.

The control unit 200 is adapted to measuring a DC voltage to input cabling 302a which connects it to the feed configuration 230 via a first output line 301a. In this example a 24 volt DC voltage is supplied from the control unit 200 to the feed configuration. According to an example, a DC voltage within a range of between 10 and 36 volts is supplied from the control unit 200 to the feed configuration. The feed configuration has a first input line 303a in electrical contact with the input cabling 302a. The control unit 200 is thus connectable to the feed configuration via the input cabling 302a.

The control unit 200 is similarly in electrical contact with output cabling 302b which connects it to the feed configuration via a second input line 301b. The feed configuration has a second output line 303b in electrical contact with the output cabling 302b. The control unit 200 is thus connectable to the feed configuration via the output cabling 302b.

The feed configuration comprises the electrical conversion unit 310 which is adapted to converting DC feed voltage to three-phase voltage and to supplying the electric motor 330 in a conventional way by means of a six-pulse bridge. The electric motor comprises a stator and a rotor in a conventional way. In this example the electric motor 330 is adapted to driving a pump 340 at a speed demanded by the control unit 200 and communicated via the link 292.

The lines 301b, 302b and 303b constitute a return side of the system depicted in Figure 3a. As illustrated in Figure 3a, the control unit 200 is adapted to continuously detecting a voltage across a resistor R situated downstream of the output cabling 302b. A voltmeter U depicted schematically on the line 303 is adapted to continuously determining a prevailing voltage across the resistor R. Downstream of the resistor R the circuit is connected to earth. A voltage determined on the return side in the circuit downstream of the output cabling 302b is received by the control unit 200 in the form of a response signal S via the line 303. The control unit 200 is adapted to converting the voltage signal detected, which contains information about prevailing voltage across the resistor R, to a current signal. This current signal is herein also referred to as the response signal. According to an alternative version, the response signal S is detected by the control unit 200 on the first output line 301a. According to a version the innovative method is applied in a way similar to that described above, with the resistor R on the line 301b.

Figure 3b illustrates schematically the response signal S of the control unit 200 depicted in Figure 3a, according to an embodiment of the invention.

A response signal S is here illustrated in the form of a wave. The shape of the response signal S is determined by conditions in the feed configuration 230 and/or the input cabling 302a and the output cabling 302b and/or the first input line 303a and/or the second output line 303b. An amplitude of the response signal S is here plotted against time t. The amplitude is in milliamperes [mA] and the time t in seconds [s].

This version indicates a number of v1-vn peak values, where n is a positive whole number. It may thus be found that all of the v1-vn peak values exceed a threshold level Th during a period of about 5 seconds. Th may be any suitable level, e.g. 25 mA. In this example it may according to an aspect of the invention be found that there is no unwanted operating state, i.e. that the electric motor 330 is running in a substantially desirable way.

Figure 3c illustrates schematically the response signal S of the control unit 200 depicted in Figure 3a, according to an embodiment of the invention.

The response signal S is here illustrated in the form of a wave. The shape of the response signal S is determined by conditions in the feed configuration 230 and/or the input cabling 302a and the output cabling 302b and/or the first input line 303a and/or the second output line 303b. An amplitude of the response signal S is here plotted against time t. The amplitude is in milliamperes [mA] and the time t in seconds [s].

This version indicates a number of v1-vn peak values, where n is a positive whole number. It may thus be found that all of the v1-vn peak values are below a threshold level Th over a predetermined period of time T. In this example the predetermined time T is about 5 seconds. The predetermined time T may be of any suitable length. The threshold level Th may be any suitable level, e.g. 25 mA. In this example it may according to an aspect of the invention be found that there is an unwanted operating state, i.e. that the electric motor 330 is not running in a desirable way.

Determination of the v1-vn peak values may be done by cross-sampling the response signal S. The result is a robust way of determining all of the v1-vn peak values.

According to the invention, a malfunction of any kind may thus be detected. An example is where the input cabling 302a and/or the output cabling 302b may have been interrupted, e.g. by an actual break in the cabling or by an incomplete connection between the control unit 200 and the feed configuration 230, particularly at any of the circuit points on the input cabling 302a and the lines 301a and/or 303a, or at any of the circuit points on the output cabling 302b and the lines 301b and/or 303b.

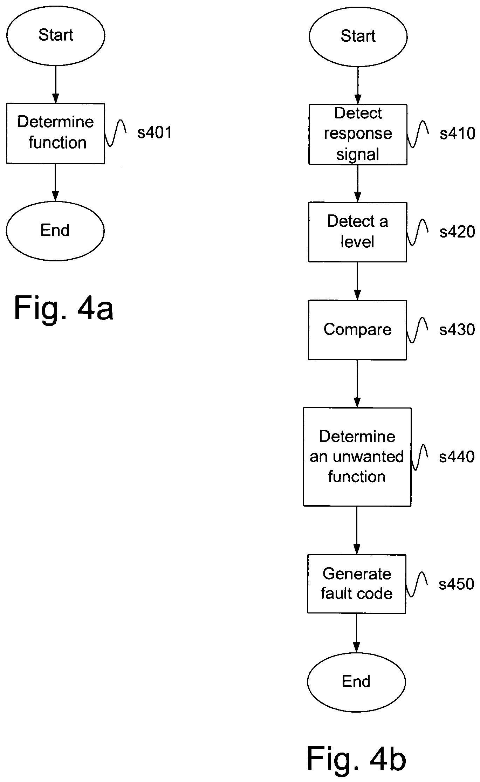

Various fault states may be determined in an operating situation where all of the peak values of the response signal S are below a predetermined threshold level Th over a predetermined period of time T. Examples of various fault states are indicated below with reference to Figure 4b.

The response signal S may be divided into a number of wave motion periods. Figure 3c indicates such a wave motion period V. In this example the period V is defined as extending between a third peak value v3 and a tenth peak value v10 of the response signal S. The wave motion period may be defined in any suitable way. According to an aspect of the invention, v1-vn levels detected of specific sections of the response signal S relate to a highest v1-vn level within said predetermined wave motion period V.

Figure 4a is a schematic flowchart of a method for function detection in a feed configuration which comprises feed lines, an electronic conversion unit and a three-phase electric motor, according to an embodiment of the invention. The method comprises a first step s401 comprising the steps of:
- detecting a response signal in a feed line for the feed configuration,
- detecting levels of specific sections of said response signal,
- comparing levels thus detected of said specific sections of said response signal with a predetermined threshold level over a predetermined period of time T, and
- determining an unwanted function of the feed configuration if all of the levels thus detected of said specific sections of said response signal are below said predetermined threshold level over said predetermined period of time T. The method ends after step s401.

Figure 4b is a schematic flowchart of a method for function detection in a feed configuration which comprises feed lines, an electronic conversion unit and a three-phase electric motor, according to an embodiment of the invention.

The method comprises a first step s410 comprising the step of detecting a response signal S in a feed line for the feed configuration. According to an example, said response signal S is detected in a feed line 301b on a return side of the feed configuration. According to another example, said response signal S is detected in a feed line 301a on a so-called plus side of the feed configuration (upstream of the input cabling 302a). This is done according to an example by continuously determining a prevailing voltage V across the resistor R of the first control unit 200. The voltage signal detected may be continuously converted to a corresponding current signal S. An example of a simple and robust way of doing this is by applying Ohm's law, since the electrical resistance of the resistor R is predetermined. According to an alternative, selected voltage levels of the voltage signal may be determined and corresponding current values be arrived at by applying a prestored table of current values based on the electrical resistance of the resistor R. Step s410 is followed by a step s420.

Method step s420 comprises the step of detecting levels of specific sections of said response signal S. According to an example, a section composed of a number of chosen points round various peak values of the response signal S may be used to detect said levels. Said levels may for example be defined as a mean value of said chosen points in the respective section of the response signal S. According to an example, a v1-vn peak value in a respective section of the response signal S is detected, where n is a positive whole number. These v1-vn peak values constitute said levels of the respective specific sections of said response signal S. Step s420 is followed by a step s430.

Method step s430 comprises the step of comparing levels thus detected of said specific sections of said response signal S with a predetermined threshold level Th over a predetermined period of time T. Said threshold level Th is a predetermined suitable threshold level, e.g. 25 mV. Step s430 is followed by a step s440.

Method step s440 comprises the step of finding that there is an unwanted function of the feed configuration if all of the levels thus detected of said specific sections of said response signal S are below said predetermined threshold level over said predetermined period of time T.

Finding said unwanted function may for example be based on comparing all of the v1-vn peak values detected within the predetermined period of time T with the threshold level Th. If all of the v1-vn peak values are below said threshold level, there is found to be a prevailing unwanted function of the feed configuration.

According to an example, a highest peak value may be determined within a number of sections of the response signal S when using all of the selected v1-vn peak values for said comparison with the threshold level Th.

According to an example, a highest peak value may be determined within a number of sections of the response signal S when using only the highest of the selected v1-vn peak values for said comparison with the threshold level Th.

According to another example, a highest peak value may be determined within a number of sections of the response signal S when using a mean value of the selected v1-vn peak values for said comparison with the threshold level Th.

Said unwanted function of the feed configuration may be any of the following:
1) Malfunction of the electrical conversion unit (internal fault).
2) Malfunction of the motor (internal fault).
3) Short-circuit to earth of the input cabling 302a and/or the output cabling 302b.
4) Break on the input cabling 302a and/or the output cabling 302b.
5) Faulty connection of the input cabling 302a and/or the output cabling 302b.
6) Break on the line 303a and/or the line 303b.
7) Break on the line 301a and/or the line 301b (upstream of the resistor R).

Said unwanted function of the feed configuration means that the electric motor 330 is not rotating despite a certain speed having been demanded of it by the control unit 200.

Step s440 is followed by a step s450.

Method step s450 comprises the step of generating a fault code on the basis of determining said unwanted function of the feed configuration. Said fault code may for example be used to generate a signal Sfault in the control unit 200. Said signal Sfault may be sent to an information unit, e.g. a display screen, enabling a driver or mechanic to become aware that there is an unwanted function of the feed configuration. The method ends after step s450.

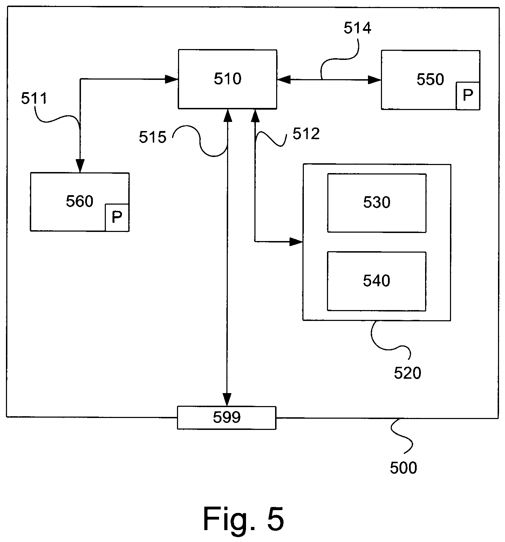

Figure 5 is a diagram of a version of a device 500. The control units 200 and 210 described with reference to Figure 2 may in a version comprise the device 500. The control unit in the conversion unit 310 may also comprise the device 500. The device 500 comprises a non-volatile memory 520, a data processing unit 510 and a read/write memory 550. The non-volatile memory 520 has a first memory element 530 in which a computer programme, e.g. an operating system, is stored for controlling the function of the device 500. The device 500 further comprises a bus controller, a serial communication port, I/O means, an A/D converter, a time and date input and transfer unit, an event counter and an interruption controller (not depicted). The non-volatile memory 520 has also a second memory element 540.

A proposed computer programme P comprises routines for function detection in a feed configuration, according to the innovative method. The programme P comprises routines for detecting a response signal S in a feed line for the feed configuration. The programme P may comprise routines for detecting a response signal S in one of the feed lines on a return side of the feed configuration 230. The programme P comprises routines for detecting levels of specific sections of said response signal S. The programme P comprises routines for comparing levels thus detected of said specific sections of said response signal S with a predetermined threshold level over a predetermined period of time T. The programme P comprises routines for determining an unwanted function of the feed configuration if all of the levels thus detected of said specific sections of said response signal S are below said predetermined threshold level over said predetermined period of time T. The programme P comprises routines for generating a fault code on the basis of said unwanted function found in the feed configuration. The programme P may be stored in an executable form or in compressed form in a memory 560 and/or in a read/write memory 550.

Where the data processing unit 510 is described as performing a certain function, it means that it effects a certain part of the programme stored in the memory 560, or a certain part of the programme stored in the read/write memory 550.

The data processing device 510 can communicate with a data port 599 via a data bus 515. The non-volatile memory 520 is intended for communication with the data processing unit 510 via a data bus 512. The separate memory 560 is intended to communicate with the data processing unit 510 via a data bus 511. The read/write memory 550 is adapted to communicating with the data processing unit 510 via a data bus 514. The data port 599 may for example have the link 292 connected to it (see Figure 2 and Figure 3a). The lines 303, 304 and 305 may also be connected to the data port 599. The data processing device is thus adapted to detecting a response signal S by processing the response signal S received via the line 303 according to a version of the invention.

When data are received on the data port 599, they are stored temporarily in the second memory element 540. When input data received have been temporarily stored, the data processing unit 510 is prepared to effect code execution as described above. According to a version, signals received on the data port 599 contain information about a prevailing voltage across the resistor R. The signals received on the data port 599 may be used by the device 500 for function detection.

Parts of the methods herein described may be effected by the device 500 by means of the data processing unit 510 which runs the programme stored in the memory 560 or the read/write memory 550. When the device 500 runs the programme, methods herein described are executed.

The foregoing description of the preferred embodiments of the present invention is provided for illustrative and descriptive purposes. It is not intended to be exhaustive nor to restrict the invention to the variants described. Many modifications and variations will obviously suggest themselves to one skilled in the art. The embodiments have been chosen and described in order best to explain the principles of the invention and their practical applications and hence make it possible for specialists to understand the invention for various embodiments and with the various modifications appropriate to the intended use.

## Claims

1. A method for function detection in a feed configuration (230; 302a; 302b; 303a; 303b) which comprises feed lines (302a; 302b; 303a; 303b), an electronic conversion unit (310; 230) and a three-phase electric motor (230; 330), comprising the steps of:
- detecting (s410) a response signal (S) in a feed line (301a; 301b) for the feed configuration (230; 302a; 302b; 303a; 303b),
- detecting (s420) levels (v1-vn) of specific sections of said response signal (S),
- comparing (s430) levels (v1-vn) thus detected of said specific sections of said response signal (S) with a predetermined threshold level (Th) over a predetermined period of time (T), and **characterised by**
- determining (s440) an unwanted function of the feed configuration (230; 302a; 302b; 303a; 303b) if all of the levels (v1-vn) thus detected of said specific sections of said response signal (S) are below said predetermined threshold level (Th) over said predetermined period of time (T).

2. A method according to claim 1, whereby said unwanted function is determined by means of a unit (200; 210; 500) which is separate from the feed configuration (230; 302a; 302b; 303a; 303b).

3. A method according to claim 1 or 2, whereby said response signal (S) is detected in the form of a current signal.

4. A method according to claim 3, whereby said specific sections of said response signal (S) comprise a peak value (v1-vn) of the current signal.

5. A method according to any one of the foregoing claims, further comprising the step of comparing said threshold level with certain levels (v1-vn) detected of said specific sections of said response signal (S).

6. A method according to claim 5, whereby said levels (v1-vn) detected of said specific sections of said response signal (S) relate to a highest level (v1-vn) within predetermined wave motion periods (V).

7. A method according to any one of the foregoing claims, whereby said predetermined time period (T) is within a range of between 0.5 and 10 seconds.

8. A method according to any one of the foregoing claims, whereby said threshold level (Th) is within a range of between 10 and 100 mA.

9. A method according to any one of the foregoing claims, whereby the feed configuration (230; 302a; 302b; 303a; 303b) relates to an arrangement for a reducing agent pump (340; 230) for an exhaust cleaning arrangement.

10. A device for function detection in a feed configuration (230; 302a; 302b; 303a; 303b) which comprises feed lines (302a; 302b; 303a; 303b), an electronic conversion unit (310; 230) and a three-phase electric motor (230; 330), comprising:
- means (200; 210; 500) configured to detect a response signal (S) in a feed line (301a; 301b) for the feed configuration (230; 302a; 302b; 303a; 303b),
- means (200; 210; 500) configured to detect levels of specific sections of said response signal (S),
- means (200; 210; 500) configured to compare levels thus detected of said specific sections of said response signal (S) with a predetermined threshold level (Th) over a predetermined period of time (T), and **characterised by**
- means (200; 210; 500) configured to determine an unwanted function of the feed configuration (230; 302a; 302b; 303a; 303b) if all of the levels thus detected of said specific sections of said response signal (S) are below said predetermined threshold level (Th) over said predetermined period of time (T).

11. A device according to claim 10, whereby said means configured to determine an unwanted function is a unit (200; 210; 500) which is separate from the feed configuration (230; 302a; 302b; 303a; 303b).

12. A device according to claim 10 or 11, in which said means (200; 210; 500) configured to detect the response signal (S) are adapted to detecting a current signal.

13. A device according to claim 12, in which said specific sections of said response signal (S) comprise a peak value (v1-vn) of the current signal.

14. A device according to any one of claims 10-13, further comprising means (200; 210; 500) configured to compare said threshold level (Th) with certain levels (v1-vn) detected of said specific sections of said response signal (S).

15. A device according to claim 14, in which said levels (v1-vn) detected of said specific sections of said response signal (S) relate to a highest level within substantially wave motion periods (V).

16. A device according to any one of claims 10-15, in which said predetermined period of time (T) is within a range of between 0.5 and 10 seconds.

17. A device according to any one of claims 10-16, in which said threshold level (Th) is within a range of between 10 and 100 mA.

18. A device according to any one of claims 10-17, in which the feed configuration relates to an arrangement for a reducing agent pump (340) for an exhaust cleaning arrangement.

19. A motor vehicle (100; 110) provided with a device according to any one of claims 10-18.

20. A motor vehicle (100; 110) according to claim 19, which vehicle is any from among truck, bus or car.

21. A computer programme (P) for function detection in a feed configuration (230; 302a; 302b; 303a; 303b) which comprises feed lines (302a; 302b; 303a; 303b), an electronic conversion unit (310; 230) and a three-phase electric motor (230; 330), which programme (P) contains programme code for causing an electronic control unit (200; 500) or another computer (210; 500) connected to the electronic control unit (200; 500) to perform steps according to any of claims 1-9.

22. A computer programme product containing a programme code stored on a computer-readable medium for performing method steps according to any of claims 1-9 when said computer programme is run on an electronic control unit (200; 500) or another computer (210; 500) connected to the electronic control unit (200; 500)

## Patentansprüche

1. Verfahren zur Funktionsdetektion in einer Einspeisungskonfiguration (230; 302a; 302b; 303a; 303b), die Zuleitungen (302a; 302b; 303a; 303b), eine elektronische Umwandlungseinheit (310; 230) und einen Drehstrom-Elektromotor (230; 330) umfasst, umfassend die Schritte zum:
- Detektieren (s410) eines Antwortsignals (S) auf einer Zuleitung (301a; 301b) für die Einspeisungskonfiguration (230; 302a; 302b; 303a; 303b),
- Detektieren (s420) von Pegeln (v1 bis vn) von spezifischen Abschnitten des Antwortsignals (S),
- Vergleichen (s430) der somit detektierten Pegel (v1 bis vn) der spezifischen Abschnitte des Antwortsignals (S) mit einem vorbestimmten Schwellenpegel (Th) während eines vorbestimmten Zeitraums (T), und
**gekennzeichnet durch**
- Bestimmen (s440) einer unerwünschten Funktion der Einspeisungskonfiguration (230; 302a; 302b; 303a; 303b), falls alle der somit detektierten Pegel (v1 bis vn) der spezifischen Abschnitte des Antwortsignals (S) während des vorbestimmten Zeitraums (T) unter dem vorbestimmten Schwellenpegel (Th) liegen.

2. Verfahren nach Anspruch 1, wobei die unerwünschte Funktion anhand einer Einheit (200; 210; 500) bestimmt wird, die von der Einspeisungskonfiguration (230; 302a; 302b; 303a; 303b) getrennt ist.

3. Verfahren nach Anspruch 1 oder 2, wobei das Antwortsignal (S) in der Form eines Stromsignals detektiert wird.

4. Verfahren nach Anspruch 3, wobei die spezifischen Abschnitte des Antwortsignals (S) einen Spitzenwert (v1 bis vn) des Stromsignals umfassen.

5. Verfahren nach einem der vorhergehenden Ansprüche, ferner umfassend den Schritt des Vergleichens des Schwellenpegels mit gewissen Pegeln (v1 bis vn), die von den spezifischen Abschnitten des Antwortsignals (S) detektiert werden.

6. Verfahren nach Anspruch 5, wobei die Pegel (v1 bis vn), die von den spezifischen Abschnitten des Antwortsignals (S) detektiert werden, mit einem höchsten Pegel (v1 bis vn) innerhalb von vorbestimmten Wellenbewegungsperioden (V) zusammenhängen.

7. Verfahren nach einem der vorhergehenden Ansprüche, wobei der vorbestimmte Zeitraum (T) in einem Bereich von 0,5 bis 10 Sekunden liegt.

8. Verfahren nach einem der vorhergehenden Ansprüche, wobei der Schwellenpegel (Th) in einem Bereich von 10 bis 100 mA liegt.

9. Verfahren nach einem der vorhergehenden Ansprüche, wobei die Einspeisungskonfiguration (230; 302a; 302b; 303a; 303b) mit einer Anordnung für eine Reduktionsmittelpumpe (340; 230) für eine Abgasreinigungsanordnung zusammenhängt.

10. Vorrichtung zur Funktionsdetektion in einer Einspeisungskonfiguration (230; 302a; 302b; 303a; 303b), die Zuleitungen (302a; 302b; 303a; 303b), eine elektronische Umwandlungseinheit (310; 230) und einen Drehstrom-Elektromotor (230; 330) umfasst, umfassend:
- Mittel (200; 210; 500), die konfiguriert sind, um ein Antwortsignal (S) auf einer Zuleitung (301a; 301b) für die Einspeisungskonfiguration (230; 302a; 302b; 303a; 303b) zu detektieren,
- Mittel (200; 210; 500), die konfiguriert sind, um Pegel von spezifischen Abschnitten des Antwortsignals (S) zu detektieren,
- Mittel (200; 210; 500), die konfiguriert sind, um die somit detektierten Pegel der spezifischen Abschnitte des Antwortsignals (S) mit einem vorbestimmten Schwellenpegel (Th) während eines vorbestimmten Zeitraums (T) zu vergleichen, und
**gekennzeichnet durch**
- Mittel (200; 210; 500), die konfiguriert sind, um eine unerwünschte Funktion der Einspeisungskonfiguration (230; 302a; 302b; 303a; 303b) zu bestimmen, falls alle der somit detektierten Pegel der spezifischen Abschnitte des Antwortsignals (S) während des vorbestimmten Zeitraums (T) unter dem vorbestimmten Schwellenpegel (Th) liegen.

11. Vorrichtung nach Anspruch 10, wobei das Mittel, das konfiguriert ist, um eine ungewünschte Funktion zu bestimmen, eine Einheit (200; 210; 500) ist, die von der Einspeisungskonfiguration (230; 302a; 302b; 303a; 303b) getrennt ist.

12. Vorrichtung nach Anspruch 10 oder 11, bei der die Mittel (200; 210; 500), die konfiguriert sind, um das Antwortsignal (S) zu detektieren, geeignet sind, um ein Stromsignal zu detektieren.

13. Vorrichtung nach Anspruch 12, bei der die spezifischen Abschnitte des Antwortsignals (S) einen Spitzenwert (v1 bis vn) des Stromsignals umfassen.

14. Vorrichtung nach einem der Ansprüche 10 bis 13, ferner umfassend Mittel (200; 210; 500), die konfiguriert sind, um den Schwellenpegel (Th) mit gewissen Pegeln (v1 bis vn), die von den spezifischen Abschnitten des Antwortsignals (S) detektiert werden, zu vergleichen.

15. Vorrichtung nach Anspruch 14, bei der die Pegel (v1 bis vn), die von den spezifischen Abschnitten des Antwortsignals (S) detektiert werden, mit einem höchsten Pegel im Wesentlichen innerhalb von Wellenbewegungsperioden (V) zusammenhängen.

16. Vorrichtung nach einem der Ansprüche 10 bis 15, bei welcher der vorbestimmte Zeitraum (T) in einem Bereich von 0,5 bis 10 Sekunden liegt.

17. Vorrichtung nach einem der Ansprüche 10 bis 16, bei welcher der Schwellenpegel (Th) in einem Bereich von 10 bis 100 mA liegt.

18. Vorrichtung nach einem der Ansprüche 10 bis 17, bei der die Einspeisungskonfiguration mit einer Anordnung für eine Reduktionsmittelpumpe (340) für eine Abgasreinigungsanordnung zusammenhängt.

19. Kraftfahrzeug (100; 110), das mit einer Vorrichtung nach einem der Ansprüche 10 bis 18 versehen ist.

20. Kraftfahrzeug (100; 110) nach Anspruch 19, wobei das Fahrzeug eines von einem Lastwagen, einem Bus oder einem Auto ist.

21. Computerprogramm (P) zur Funktionsdetektion in einer Einspeisungskonfiguration (230; 302a; 302b; 303a; 303b), die Zuleitungen (302a; 302b; 303a; 303b), eine elektronische Umwandlungseinheit (310; 230) und einen Drehstrom-Elektromotor (230; 330) umfasst, wobei das Programm (P) Programmcode enthält, um zu bewirken, dass eine elektronische Steuereinheit (200; 500) oder ein anderer Computer (210; 500), der an die elektronische Steuereinheit (200; 500) angeschlossen ist, die Schritte nach einem der Ansprüche 1 bis 9 ausführt.

22. Computerprogrammprodukt, das Programmcode enthält, der auf einem computerlesbaren Medium gespeichert ist, um die Verfahrensschritte nach einem der Ansprüche 1 bis 9 auszuführen, wenn das Computerprogramm auf einer elektronischen Steuereinheit (200; 500) oder einem anderen Computer (210; 500), der an die elektronische Steuereinheit (200; 500) angeschlossen ist, abläuft.

## Revendications

1. Procédé de détection d'un défaut de fonctionnement d'un système d'alimentation (230 ; 302a ; 302b ; 303a ; 303b) qui comprend des conduites d'alimentation (302a ; 302b ; 303a ; 303b), une unité de conversion électronique (310 ; 230) et un moteur électrique triphasé (230 ; 330), comprenant les étapes de :
- détection (s410) d'un signal de réponse (S) dans une conduite d'alimentation (301a ; 301b) du système d'alimentation (230 ; 302a ; 302b ; 303a ; 303b),
- détection (s420) de niveaux (v1-vn) de sections spécifiques dudit signal de réponse (S),
- comparaison (s430) des niveaux (v1-vn) ainsi détectés desdites sections spécifiques dudit signal de réponse (S) à un niveau seuil préétabli (Th) sur une période de temps prédéterminée (T), et **caractérisé par**
- la détermination (s440) d'un fonctionnement non souhaité du système d'alimentation (230 ; 302a ; 302b ; 303a ; 303b) si tous les niveaux (v1-vn) ainsi détectés desdites sections spécifiques dudit signal de réponse (S) sont inférieurs audit niveau seuil préétabli (Th) sur ladite période de temps prédéterminée (T).

2. Procédé selon la revendication 1, **caractérisé en ce que** ledit fonctionnement non souhaité est déterminé au moyen d'une unité (200 ; 210 ; 500) distincte du système d'alimentation (230 ; 302a ; 302b ; 303a ; 303b).

3. Procédé selon la revendication 1 ou 2, **caractérisé en ce que** ledit signal de réponse (S) est détecté sous la forme d'un signal de courant.

4. Procédé selon la revendication 3, **caractérisé en ce que** lesdites sections spécifiques dudit signal de réponse (S) comprennent une valeur de crête (v1-vn) du signal de courant.

5. Procédé selon l'une quelconque des revendications précédentes, comprenant en outre l'étape consistant à comparer ledit niveau seuil à certains niveaux (v1-vn) détectés desdites sections spécifiques dudit signal de réponse (S).

6. Procédé selon la revendication 5, **caractérisé en ce que** lesdits niveaux (v1-vn) détectés desdites sections spécifiques dudit signal de réponse (S) se rapportent à un niveau le plus élevé (v1-vn) pendant des périodes de mouvements ondulatoires prédéterminées (V).

7. Procédé selon l'une quelconque des revendications précédentes, **caractérisé en ce que** ladite période de temps prédéterminée (T) est comprise entre 0,5 et 10 secondes.

8. Procédé selon l'une quelconque des revendications précédentes, **caractérisé en ce que** ledit niveau seuil (Th) est compris entre 10 et 100 mA.

9. Procédé selon l'une quelconque des revendications précédentes, **caractérisé en ce que** le système d'alimentation (230 ; 302a ; 302b ; 303a ; 303b) se rapporte à un dispositif pour une pompe d'agents réducteurs (340 ; 230) destinée à un dispositif d'épuration de gaz d'échappement.

10. Dispositif de détection d'un défaut de fonctionnement d'un système d'alimentation (230 ; 302a ; 302b ; 303a ; 303b) qui comprend des conduites d'alimentation (302a ; 302b ; 303a ; 303b), une unité de conversion électronique (310 ; 230) et un moteur électrique triphasé (230 ; 330), comprenant :
- un moyen (200 ; 210 ; 500) configuré pour détecter un signal de réponse (S) dans une conduite d'alimentation (301a ; 301b) du système d'alimentation (230 ; 302a ; 302b ; 303a ; 303b),
- un moyen (200 ; 210 ; 500) configuré pour détecter des niveaux de sections spécifiques dudit signal de réponse (S),
- un moyen (200 ; 210 ; 500) configuré pour comparer les niveaux ainsi détectés desdites sections spécifiques dudit signal de réponse (S) à un niveau seuil préétabli (Th) sur une période de temps prédéterminée (T), et **caractérisé par**
- un moyen (200 ; 210 ; 500) configuré pour déterminer un fonctionnement non souhaité du système d'alimentation (230 ; 302a ; 302b ; 303a ; 303b) si tous les niveaux ainsi détectés desdites sections spécifiques dudit signal de réponse (S) sont inférieures audit niveau seuil préétabli (Th) sur ladite période de temps prédéterminée (T).

11. Dispositif selon la revendication 10, **caractérisé en ce que** ledit moyen configuré pour déterminer un fonctionnement non souhaité est une unité (200 ; 210 ; 500) distincte du système d'alimentation (230 ; 302a ; 302b ; 303a ; 303b).

12. Dispositif selon la revendication 10 ou 11, **caractérisé en ce que** lesdits moyens (200 ; 210 ; 500) configurés pour détecter le signal de réponse (S) sont conçus pour détecter un signal de courant.

13. Dispositif selon la revendication 12, dans lequel lesdites sections spécifiques dudit signal de réponse (S) comprennent une valeur de crête (v1-vn) du signal de courant.

14. Dispositif selon l'une quelconque des revendications 10 à 13, comprenant en outre un moyen (200 ; 210 ; 500) configuré pour comparer ledit niveau seuil (Th) à certains niveaux (v1-vn) détectés desdites sections spécifiques dudit signal de réponse (S).

15. Dispositif selon la revendication 14, dans lequel lesdits niveaux (v1-vn) détectés desdites sections spécifiques dudit signal de réponse (S) se rapportent à un niveau le plus élevé pendant des périodes de mouvements ondulatoires (V) considérables.

16. Dispositif selon l'une quelconque des revendications 10 à 15, dans lequel ladite période de temps (T) prédéterminée est comprise entre 0,5 et 10 secondes.

17. Dispositif selon l'une quelconque des revendications 10 à 16, dans lequel ledit niveau seuil (Th) est compris entre 10 et 100 mA.

18. Dispositif selon l'une quelconque des revendications 10 à 17, dans lequel le système de l'alimentation se rapporte à un dispositif pour une pompe d'agents réducteurs (340) destinée à un dispositif d'épuration de gaz d'échappement.

19. Véhicule à moteur (100 ; 110) muni d'un dispositif selon l'une quelconque des revendications 10 à 18.

20. Véhicule à moteur (100 ; 110) selon la revendication 19, le véhicule étant l'un quelconque parmi un camion, un autobus ou une voiture.

21. Programme informatique (P) destiné à la détection d'un défaut de fonctionnement d'un système d'alimentation (230 ; 302a ; 302b ; 303a ; 303b) comprenant des conduites d'alimentation (302a ; 302b ; 303a ; 303b), une unité de conversion électronique (310 ; 230) et un moteur électrique triphasé (230 ; 330), lequel programme (P) comprend un code de programme destiné à amener une unité de commande électronique (200 ; 500) ou un autre ordinateur (210 ; 500) connecté à l'unité de commande électronique (200 ; 500) à réaliser des étapes selon l'une quelconque des revendications 1 à 9.

22. Produit de programme informatique comprenant un code de programme stocké sur un support lisible par ordinateur destiné à réaliser des étapes de procédé selon l'une quelconque des revendications 1 à 9, lorsque ledit programme informatique est exécuté sur une unité de commande électronique (200 ; 500) ou sur un autre ordinateur (210 ; 500) connecté à l'unité de commande électronique (200 ; 500).
